# EUROPEAN PATENT APPLICATION

(11) **EP 0 957 489 A1**
(43) Date of publication of application: **17.11.1999**
(21) Application number: 98203972.9
(22) Date of filing: 24.11.1998
(51) Int. Cl.: G11C 7/00

(54) **Portable device and method to record, edit and playback digital audio**

(30) Priority: 11.05.1998 EP 98201519
(71) Applicant: Van de Pol, Teun, 6661 NE Elst (Gld) (NL)
(72) Inventor: Van de Pol, Teun, 6661 NE Elst (Gld) (NL)

(57) **Abstract**

An apparatus for recording, storing, editing and reproducing digital audio comprises a fast and reliable internal storage means using e.g. flash memory. This storage means also buffers audio recorded in the stand-by mode during an adjustable time. It also comprises a means to detect silence which is not written to the storage means so that the storage means is used efficiently. A verification method is used when storing audio. Also an audio editing method is used making it easy to create, store and reproduce audio. The apparatus not only has an internal storage but also an external storage medium. It transmits audio to other systems by using a standard digital output and a PCMCIA communication port.

## Description

### BACKGROUND OF THE INVENTION

### Field of the Invention

The invention relates to a portable device without tapes carried out without moving parts, except buttons for operations. It is also a method for digital recording, storage, editing and playing of audio. This device is extremely suitable to be used for digital audio with compression, for example MPEG files. The system can be used by journalists, radio stations and all other users, who wish to record, store and edit high quality audio.

### Description of the Related Art

The existing record and playback devices are either analogue or digital. Looking at the disadvantages of the analogue method, like lower audio quality and larger wear-off of the mechanical parts and the fact that searching and editing of audio fragments are very time consuming activities which must be done by a professional. The analogue method has lately more and more been pushed aside by the digital method.

The existing digital method on tape does solve the problem of the low audio quality, but here also other disadvantages remain: a mechanical device, so subject to wear off, the audio fragments are not direct accessible, and the time consuming and complicated way of editing recorded audio.

The digital method on direct accessible storage media with moving parts takes away the above mentioned disadvantages, but this device has another disadvantage, namely that it is less shock-proof, subject to wear-off of the moving parts and therefore less reliable and has shorter lifetime.

From US005491774A a portable recording and reproduction device is already known which stores digital audio on direct accessible storage media without moving parts. Such a system will take away all above mentioned disadvantages and makes use of external PCMCIA card as storage medium. This has as a disadvantage that the available storage capacity is small and expensive. The expensive cards can be stolen or get lost. Apart from the direct damage, also the possibility remains that when the device is going to be used, such a card is not available, which results in the fact that the device can not be used at all.

### OBJECTS AND SUMMARY OF THE INVENTION

It is therefore an object of the present invention to provide a portable record/playback device and method that promise easy playback and editing of high quality audio, a less expensive and reliable storage medium, a more efficient use of available storage medium and also promise a very reliable way of recording and storing audio.
**1.** An object of the invention is to provide a recording method that prevents the user losing the beginning of an important audio fragment. This time shift recording method, stores the audio signal temporarily in a memory buffer when the device is in standby mode. This memory buffer is a so called first in-first out buffer. The duration of the audio that can be stored in the FIFO buffer call be adjusted by the user. As soon as the user likes to start the recording, because the audio is getting interesting, the actual recording will be activated. From that moment on, all audio will be written to the storage media including the audio which previously had been stored in the FIFO buffer.
**2.** It is a further object of this invention to provide a recording method that promises an efficient use of the available storage medium. The smart space recording method, checks during record the incoming audio signal. When the method detects silence for a period longer than the user specified, this silence will not be written to the storage media. As soon as the method detects audio waves (again), it automatically starts writing the incoming audio to the storage media. The advantages are a substantially more efficient use of the storage device, and a cost saving due to the fact that the device can be standby for 24 hours per day and automatically starts recording when it detects audio.
**3.** A still further object of this invention is to provide a reliable recording method that makes sure that the audio will be stored correctly. The audible recording verification method, writes the audio during record to the storage medium. After every write action it will try to read the written audio back from the storage medium. If the method is able to read the audio, it will play back that specific part. This gives the user the certainty that this part has been stored correctly. In case the write action failed, the method will retry the write action several times. When it still fails after several retries, the user will be notified by headphone because the method will only playback the audio that has been correctly written to the storage media.
   If the method detects that the storage medium can not be accessed, the method will automatically switch to another storage medium, if available.
**4.** Yet another object of this invention is to provide an easy audio editing method. The editing method provides the user with functions like cutting, pasting, copying and deletion of audio. It also gives the possibility to add related data to the stored audio like audio type, audio quality, duration of audio, name, recording date and time. All these functions make it easy to create, store and reproduce audio.
**5.** According to another aspect of the invention, there is provided an internal storage medium. This internal storage medium can be of any type of memory, for example flash chips. In this way it will be possible to create a large storage medium, because there are almost no limitations to the size. This internal storage medium will be faster than an external storage medium like a PCMCIA flash disk because there are no time consuming drivers required. Because the internal storage medium is fast and large, it gives the opportunity to record also uncompressed audio.
**6.** Another object of this invention is to provide such a device which has not only an internal storage medium but also an external storage medium, With such a device it will be possible to store audio simultaneously to the internal and external storage media. In this case the audio will be available for reproduction while the device can be used for the next recording.
**7.** It is a further object of this invention to provide a device which offers several ways of transmitting audio to other systems. One way of transferring the audio is by using the PCMCIA communication port. The PCMCIA port gives the possibility to use several types of communication cards. Another way of transferring the audio is using a standard digital output like AES/EBU. This digital port can be used for real-time transmission between two audio devices. For cheap and fast transmission between the invention and for example an ordinary computer, a digital port can be used like USB, LPT or Fire Wire.
   The advantages of these transmission ways are that there's no need to copy the audio to an expensive storage medium first. There are also a lot more possibilities created to use the invention as a compatible receiver/transmitter.

### DESCRIPTION OF THE DRAWINGS

**Fig. 1** is a block diagram providing a functional layout for the present invention.
**Fig. 2** is a schematic explanation of the time shift recording method.
**Fig. 3** is a schematic explanation of the smart space recording method.

### DETAILED DESCRIPTION OF THE INVENTION

The present invention departs from long standing tradition which dictates the use of a moving medium such as tape or compact disk as a requirement for an recording device. Instead, it offers several ways of storing audio.

First of all, it offers the advantages of a removable element smaller in size than a cassette tape, but which has no moving parts. This removable component comprises a flash memory chip or module which has the capacity to store digital information without need for ongoing power support. The stored information is substantially permanent and is not susceptible to magnetic erasure or modification. This information can be immediately recovered by inserting the module into any compatible recorder or ordinary computer for immediate playback, editing or archiving.

Instead of using the removable flash memory module, it will also be possible to use a removable hard disk: a removable module having time same size as the removable flash memory module.

The present invention departs also from long standing tradition which dictates the use of removable media. Removable media can be handy but are not necessary in every situation. Because removable media are quite expensive, easy to forget and also very easy to loose, the present invention has an internal disk which has the capacity to store digital information very fast and to recover the stored information very fast for immediate playback or editing.

The present invention also provides a digital communication port for very fast and easy transport of the stored digital audio to another device like an ordinary computer.

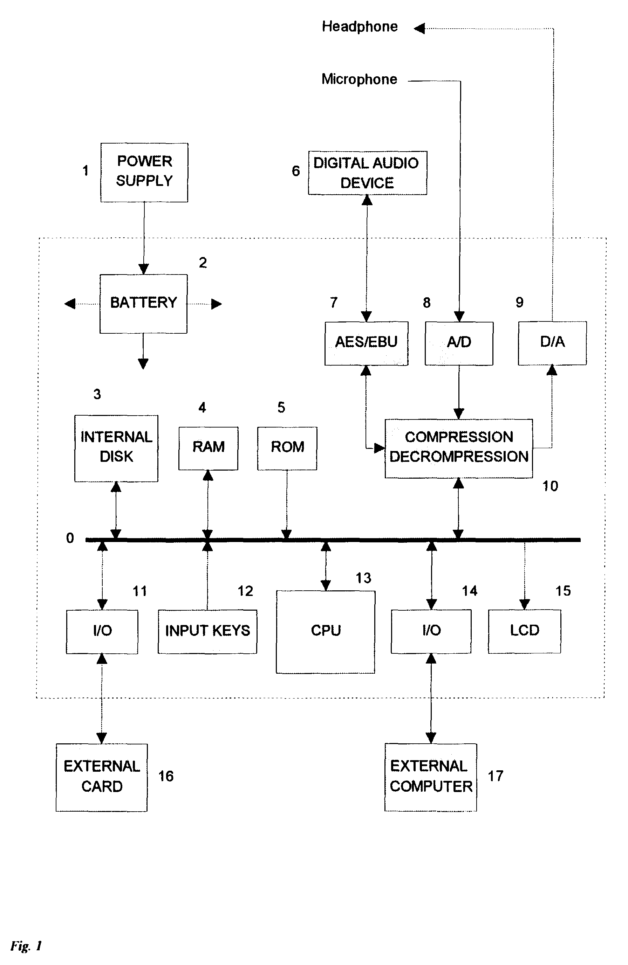

**Fig. 1** is a block diagram of the invention, a digital portable recording device. In Fig. 1, the digital portable recorder has a CPU (13) for controlling the entirety. Connected to a bus (0) from CPU (13) are ROM (5) and RAM (4). Further an internal storage medium (3) for storing audio data and a compression / decompression circuit (10) for compressing and expanding audio data. Additionally connected to the bus (0) are an I/O port (11) for connecting a card (16) to add various functions like an external storage device for backup or transport, an I/O port (14) for connecting an external computer (17) to transmit stored audio from the recording device to the connected external computer (17). A liquid display (15) and input keys are further connected to the bus (0).

The portable device can be powered by an internal removable battery pack (2) or can be powered by an external power supply (1). When connected to an external power supply (1), power will be supplied to the recording device but also to the battery (2) of the recording device to electrically charge the battery (2).

To store an audio signal from the microphone, a record command is given through the input key (12). In response to the record command, the audio signal from the microphone is supplied to the A/D converter (8), and converted into a digital form. The audio data is then supplied to and compressed by the compression / decompression circuit (10). The compressed audio data is delivered to the internal disk (3) through the bus (0), and stored there. Simultaneously, the compressed audio data can be delivered to an external card (16) through bus (0) and I/O port (11), and stored there.

To reproduce data stored on the internal disk (3), a reproduction command is given through the input key (12). In response to the command, compressed audio data is read from the internal disk (3), and delivered to the compression/decompression circuit (10). The circuit (10) expands the audio data that has been compressed by MPEG, for example. The expanded audio data is supplied to the headphone through D/A converter (9).

To reproduce data stored on an external disk (16), a reproduction command is given through the input key (12). In response to the command, compressed audio data is read from the external disk (16), and delivered to the audio compression/decompression circuit (10). The circuit (10) expands the audio data that has been compressed by MPEG, for example. The expanded audio data is supplied to the headphone through the D/A converter (9).

To copy digital data from the internal disk (3) to an external digital recording device (6) like a DAT, the external digital recording device (6) is connected to the digital output (7). A reproduction command is given through the input key (12). In response to the reproduction command, compressed audio data are read from the internal disk (3), and delivered to the digital output (7). The external digital recording device (6) records the incoming audio data from the digital output (7) without converting the digital audio to analog audio. This means no loss of audio quality.

To copy digital data from the internal disk (3) to an external computer (17), the computer is connected to the I/O port (14). A copy command is given through the input key (12). In response to the command, data are read from internal disk (3), and delivered to the I/O port (14).

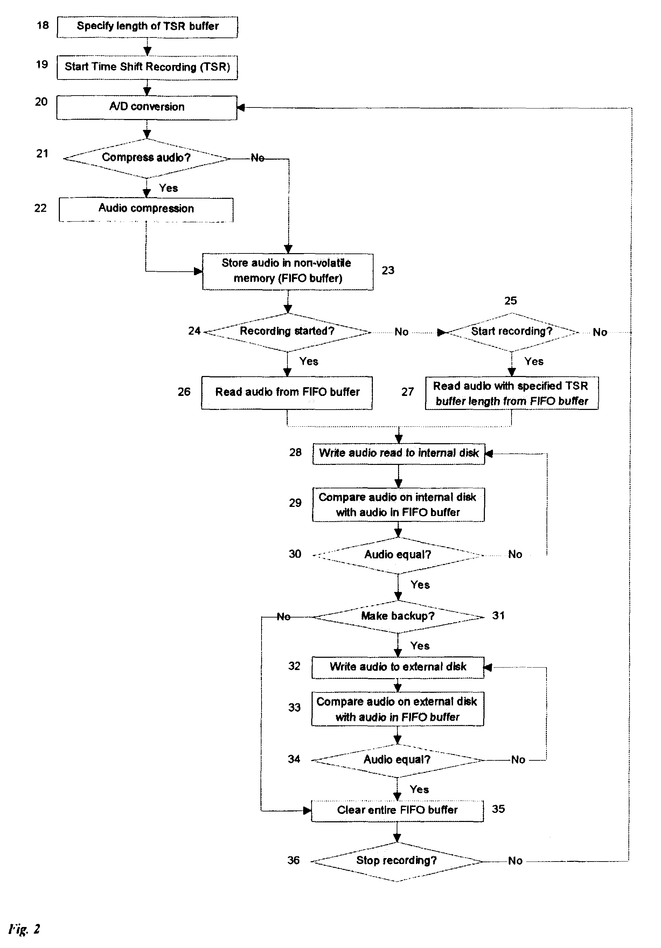

**Fig. 2** is a schematic explanation of one part of the invention. This part of the invention is the time shift recording method, a possible way of storing an audio signal from the microphone. Because digital audio needs a lot of storage space, users of a portable digital recorder start recording only then when there is something interesting to record. Unfortunately, very often users find out that they started the recording just a few seconds too late. To eliminate the problem of missing the first few seconds, the invention has a special way of recording and storing digital audio: the time shift recording method. The time shift recording method stores not only the audio recorded from the moment the recording started, but it also stores the audio recorded just a few seconds before the recording actually started.

To store an audio signal from the microphone using time shift recording, a start command is given at (19). The audio signal from the microphone will be converted from analog to digital at (8, 20). The invention gives the possibility to store the audio linear or compressed, this will be checked at (21). When storing compressed, the digital audio will be compressed at (10, 22) and stored in RAM (4, 23), otherwise it will directly be stored in RAM (4, 23). The invention checks at (24) if the user is waiting for some interesting audio. If the user is still waiting the invention jumps to (20).

When the user wants to start the actual recording, a record command is given through the input key (12) at (25). In response to the record command, all audio (length specified at (18)) stored in RAM (4) at (23) will be read at (27) and written to the internal disk (3) at (28).

When the actual recording is active, audio stored in RAM (4) at (23) will be read at (26) and written to the internal disk (3) at (28). To check if the recorded audio has been written correctly to the internal disk (3), the audio in RAM (4) will be compared (29) to the audio stored on the internal disk (3). When it seems that something has gone wrong (30), it will return to (28) and try again.

Sometimes it's handy for safety and flexibility to have a backup of the recorded audio on a removable medium (16), this option will be checked at (31). If the user doesn't want a backup of the recorded audio, it clears RAM (4) at (35). If the user likes to make a backup on an external disk (16) has been connected to I/O port (11), the audio in RAM (4) will be written to the external disk (16) at (32). To check if the recorded audio has been written correctly to the external disk (16), the audio in RAM (4) will be compared (33) to the audio stored on the external disk (16). When it seems that something has been gone wrong (34), it will return to (32) and try again. When at (34) is concluded that the audio is correctly stored, the whole RAM (4) will be cleared at (35). At (36) will be checked if the user wants to stop otherwise it jumps to (20) and continues recording.

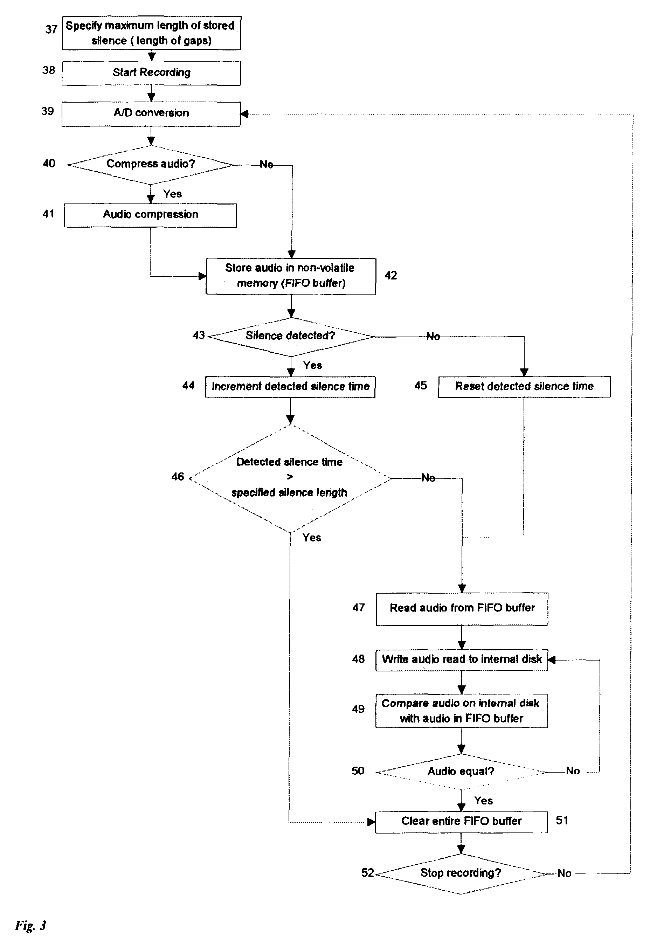

**Fig. 3** is a schematic explanation of one part of the invention. This part of the invention is the smart space recording method, a possible way of storing an audio signal from the microphone. Because digital audio needs a lot of storage space, it's a waste of space when silence recorded. If the smart space recording method detects more then a few seconds of silence, it stops storing the recorded audio, silence. The smart space recording method also gives the possibility to start a recording automatically, because it doesn't write to disk until it detects audio.

To store an audio signal from the microphone using the smart space recording method, a start command is given at (38). The audio signal from the microphone will be converted from analog to digital at (8, 39). The present invention gives the possibility to store the audio linear or compressed, this will be checked at (40). When storing compressed, the digital audio will be compressed at (10, 41) and stored in RAM (4, 42), otherwise it will directly be stored in RAM (4, 42). At (43) the recorded audio will be checked.

If there's no audio signal at (43), a silence duration counter will be incremented. At (46) will be checked if the duration of silence exceeds the length specified at (37). If the length of silence exceeds the length specified, RAM (4) will be cleared at (51).

If there's an audio signal detected at (43), the silence duration counter will be set to zero seconds. Audio stored in RAM (4) at (42) will be read at (47) and written to the internal disk (3) at (48). To check if the recorded audio has been written correctly to the internal disk (3), the audio in RAM (4) will be compared (49) to the audio stored on the internal disk (3). When it seems that something has gone wrong (50), it will return to (48) and try again.

When at (50) is concluded that the audio is correctly stored, the whole RAM (4) will be cleared at (51). At (52) will be checked if the user likes to stop the recording, otherwise it jumps to (39) and continues recording.

## Claims

1. A portable device for digital recording, storing, editing and reproducing of sound, comprising:
Control means (13) for controlling entire behaviors;
Compression circuit (10) for compressing audio data;
Decompression circuit (10) for expanding compressed audio data;
Intelligent battery (2) for supplying power to the hole system;
Fast storage means (4) for buffering audio during recording and reproducing audio data;
Digital port (7) for real-time digital audio transmission and reception;
External I/O means (11) for fast and flexible transfer of digital audio data;
Fast and reliable internal storage means (3) using flash memory, which has the capacity to store digital data without need for ongoing power support;

2. The portable device according to claim 1, wherein said storage means (3) will be replaced by a large internal hard disc which has the capacity to store a lot of digital data in a very fast way;

3. The portable device according to claim 1 and 2, wherein next to storage means (4) a card shaped recording medium (16) has been connected to I/O port (11);

4. The portable device according to claim 1 and 2, wherein next to storage means (4) a card shaped hard disc (16) has been connected to I/O port (11);

5. The portable device according to claims 1, 2, 3 and 4, wherein next to the existing I/O port (11) and digital port (7) a very fast digital communication port will be available for transferring/receiving audio data to/from other devices like an ordinary computer;

6. An audio recording method comprising the steps of:
Storing compressed audio data in storage means (4) during stand-by;
Length of storage means (4) is user adjustable;
At the moment the actual recording starts, all audio in storage means (4) will be written to storage means (3);
During actual recording all data will be written to storage means (4);
During actual recording all audio data available in storage means (4) will be read and written to storage means (3);

7. An audio recording method according to claim 6, wherein data will not be written to said storage means (3) but to an external recording medium (16);

8. An audio recording method comprising the steps of:
During stand-by all audio will be checked. When detecting silence for a period longer than the user specified, this silence will not be stored, otherwise compressed audio will be stored to storage means (4);
Length of storage means (4) is user adjustable;
At the moment the actual recording starts, all audio in storage means (4) will be written to storage means (3);
During actual recording all audio will be checked. When detecting silence for a period longer than the user specified, this silence will not be stored, otherwise compressed audio will be stored to storage means (4);
During actual recording all audio data available in storage means (4) will be read and written to storage means (3);

9. An audio recording method according to claim 8, wherein data will not be written to said storage means (3) but to an external recording medium (16);

10. An audio recording method comprising the steps of:
During actual recording all audio will be stored in storage means (4). All audio data available in storage means (4) will be read and written to storage means (3);
Audio data just written to storage means (3) will be read back from storage means (3);
If the system is able to read the audio, it will playback this audio part.
If the system is not able to read the audio back, it will retry the write action several times. If the system didn't succeed, it will try to write the audio to storage means (16);

11. The portable device according to claims 1, 2, 3, 4 and 5, which uses some or all of the recording methods according to claims 6, 7, 8, 9 and 10;
